# EUROPÄISCHE PATENTSCHRIFT

(11) **EP 1 243 030 B1**
(45) Veröffentlichungstag und Bekanntmachung des Hinweises auf die Patenterteilung: **29.09.2010**
(21) Anmeldenummer: 00988586.4
(22) Anmeldetag: 10.11.2000
(51) Int. Cl.: H01L 33/00, H01L 27/15

(54) **WEISSLICHTQUELLE AUF DER BASIS NICHTLINEARER OPTISCHER PROZESSE**
WHITE LIGHT SOURCE BASED ON NON-LINEAR OPTICAL PROCESSES
SOURCE DE LUMIERE BLANCHE SUR LA BASE DE PROCESSUS OPTIQUES NON LINEAIRES

(30) Priorität: 30.12.1999 DE 19963805
(43) Veröffentlichungstag der Anmeldung: 25.09.2002
(73) Patentinhaber: OSRAM Opto Semiconductors GmbH, 93055 Regensburg (DE)
(72) Erfinder: SPÄTH, Werner, 83607 Holzkirchen (DE); MÜLLER, Rüdiger, 93128 Regenstauf (DE)
(74) Vertreter: Epping - Hermann - Fischer
(86) Internationale Anmeldenummer: PCT/DE2000/003957
(87) Internationale Veröffentlichungsnummer: WO 2001/050539

(56) Entgegenhaltungen:
- EP-A- 0 683 595
- EP-A- 0 767 396
- DE-A- 19 510 423
- US-A- 5 295 143

## Beschreibung

Die vorliegende Erfindung betrifft eine Weißlichtquelle gemäß Patentanspruch 1 oder 2. Insbesondere betrifft die vorliegende Erfindung eine Weißlichtquelle, bei der eine Lichtemissionseinrichtung Lichtstrahlung in einem relativ langwelligen, d.h. roten oder infraroten Spektralbereich emittiert, welche durch nichtlinear-optische Prozesse in eine Ausgangsstrahlung umgewandelt wird, deren spektrale Bestandteile im wesentlichen komplementärfarbig sind, so daß die Ausgangsstrahlung als weißes Licht erscheint.

Eine Weißlichtquelle auf Basis einer Halbleiter-LED ist beispielsweise aus der deutschen Offenlegungsschrift DE 38 04 293 bekannt. Darin ist eine Anordnung mit einer Elektrolumineszenz- oder Laserdiode beschrieben, bei der das von der Diode abgestrahlte Emissionsspektrum mittels eines mit einem phosphoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte Licht. Abhängig von der Art des dem Kunststoff beigefügten Farbstoffes lassen sich mit ein- und demselben Leuchtdiodentyp Leuchtdiodenanordnungen herstellen, die in unterschiedlichen Farben leuchten.

In vielen potentiellen Anwendungsgebieten für Leuchtdioden, wie z.B. bei Anzeigeelementen im Kfz-Armaturenbereich, Beleuchtung in Flugzeugen und Autos und bei vollfahrttauglichen LED-Displays, tritt verstärkt die Forderung nach Leuchtdiodenanordnungen auf, mit denen sich mischfarbiges Licht, insbesondere weißes Licht, erzeugen läßt.

In der WO 98/12757 ist eine wellenlängenkonvertierende Vergußmasse für ein elektrolumineszierendes Bauelement mit einem ultraviolettes, blaues oder grünes Licht aussendenden Körper auf der Basis eines transparenten Epoxidharzes beschrieben, das mit einem Leuchtstoff, insbesondere mit einem anorganischen Leuchtstoffpigmentpulver mit Leuchtstoffpigmenten aus der Gruppe der Phosphore, versetzt ist. Als bevorzugtes Ausführungsbeispiel wird eine Weißlichtquelle beschrieben, bei welcher eine strahlungsemittierende Halbleiter-LED auf der Basis von GaN, GaInN, GaAlN oder GaInAlN mit einem Emissionsmaximum zwischen 420 nm und 460 nm mit einem Leuchtstoff kombiniert ist, der so gewählt ist, daß eine von dem Halbleiterkörper ausgesandte blaue Lichtstrahlung in komplementäre Wellenlängenbereiche, insbesondere blau und gelb, oder zu additiven Farbtripeln, z.B. blau, grün und rot, umgewandelt wird. Hierbei wird das gelbe bzw. das grüne und rote Licht von den Leuchtstoffen erzeugt. Der Farbton (Farbort in der CIE-Farbtafel) des solchermaßen erzeugten weißen Lichts kann dabei durch geeignete Wahl des oder der Leuchtstoffe hinsichtlich Mischung und Konzentration variiert werden.

Ebenso offenbart die WO 98/54929 ein sichtbares lichtemittierendes Halbleiterbauelement mit einer UV-/blau-LED, welche in einer Vertiefung eines Trägerkörpers angeordnet ist, deren Oberfläche eine lichtreflektierende Schicht aufweist und mit einem transparenten Material gefüllt ist, welches die LED an ihren Lichtaustrittsseiten umgibt. Zur Verbesserung der Lichtauskopplung weist das transparente Material einen Brechungsindex auf, der niedriger als der Brechungsindex der lichtaktiven Region der LED ist.

Die WO 97/50132 offenbart ein lichtabstrahlendes Halbleiterbauelement mit einem Strahlung aussendenden Halbleiterkörper und einem Lumineszenz-Konversionselement. Der Halbleiterkörper sendet Strahlung im ultravioletten, blauen und/oder grünen Spektralbereich aus und das Lumineszenz-Konversionselement wandelt einen Teil dieser Strahlung in Strahlung mit einer größeren Wellenlänge um, wodurch sich Leuchtdioden herstellen lassen, die mittels eines einzigen lichtaussendenden Halbleiterkörpers mischfarbiges Licht, insbesondere weißes Licht, abstrahlen. Als besonders bevorzugter Lumineszenz-Konversionsstoff wird Cer-dotiertes Yttrium-Aluminiumgranat (YAG:Ce) beschrieben.

Die bekannten Anordnungen haben jedoch den Nachteil, daß sie - wie beschrieben - nur mit einer im blauen oder ultravioletten Spektralbereich emittierenden Leuchtdiode oder Laserdiode betrieben werden können. Diese Lichtemitter werden üblicherweise auf der Basis von GaN oder II-VI-Verbindungen wie ZnS/Se hergestellt und die erzielbaren Lichtleistungen liegen bei einigen 10 mW.

Es ist dementsprechend Aufgabe der vorliegenden Erfindung, eine Weißlichtquelle mit einer Lichtemissionseinrichtung anzugeben, die insbesondere für höhere Lichtleistungen im Watt- und Multiwattbereich mit hoher Zuverlässigkeit und hoher Lebensdauer ausgelegt ist und routinemäßig hergestellt werden kann. Insbesondere ist es Aufgabe der vorliegenden Erfindung, eine Weißlichtquelle mit einer Laserdiode, insbesondere einer Infrarot-Laserdiode auf der Basis von III-V-Verbindungen, wie z.B. GaAlAs, GaInAlAs, GaInAs bzw. InGaAsP, die nur in der Grundmode emittiert, anzugeben.

Aus dem Dokument EP-A-0 767 396 ist bekannt, mittels Frequenzverdopplung aus einem Infrarot Laser sichtbares Licht zu erzeugen. Ausgehend von einem grünen Laserstrahl werden gemäß der Druckschrift US-A- 5 295 143 die drei Grund farben durch Pumpen von Lasern und Frequenzverdopplung erzeugt.

Diese Aufgabe wird mit den Merkmalen des Patentanspruchs 1 oder 2 gelöst.

Dementsprechend beschreibt die vorliegende Erfindung eine Weißlichtquelle mit einer Lichtemissionseinrichtung zur Emission eines Strahlungsbündels mit einer oder mehreren Strahlungsfrequenzen im roten oder infraroten Spektralbereich, einem nichtlinear-optischen Element, in welches das Strahlungsbündel eingekoppelt und zumindest teilweise durch Erzeugung von mindestens einer Mischfrequenz mittels Frequenzmischung und/oder Frequenzverdopplung und/oder Summen- oder Differenzfrequenzbildung in ein frequenzgemischtes Strahlungsbündel umgewandelt wird, und einem Konversionselement, in welches das frequenzgemischte Strahlungsbündel eingekoppelt und derart mindestens teilweise in Lichtstrahlung größerer oder kleinerer Wellenlänge umgewandelt wird, daß das Emissionsspektrum des von dem Konversionselement abgestrahlten Strahlungsbündels zueinander komplementärfarbige Spektralbereiche aufweist.

Unter einem Konversionselement ist dabei allgemein ein Element zu verstehen, das zumindest einen Teil eines Strahlungsfeldes eines ersten Wellenlängenbereichs in einen zweiten Wellenlängenbereich konvertiert. Diese Konversion kann durch Absorption und Reemission des Strahlungsfeldes erfolgen. Alternativ ist eine Konversion durch einen nichtlinearen optischen Prozeß möglich, der gegebenfalls auch resonanzverstärkt sein kann. Insbesondere fallen hierunter Lumineszenz, Summen- und Differenzfrequenzerzeugung, speziell die Generation von harmonischen und subharmonischen Frequenzen, Ramanstreuung und stimulierte Ramanstreuung.

Statt komplementärfarbiger Spektralbereiche kann das von dem Konversionselement abgestrahlte Strahlungsbündel auch Komponenten im roten, grünen und blauen Spektralbereich aufweisen, die ebenfalls zu Weißlicht gemischt werden können.

Das Grundprinzip der Erfindung besteht somit darin, eine konventionelle Lichtquelle wie eine Infrarot-Laserdiode auf der Basis von III-V-Halbleitermaterial zu verwenden und die von der Lichtquelle emittierte Lichtstrahlung mittels nichtlinear-optischer Prozesse in Weißlicht umzuwandeln.

In einer ersten Ausführungsform ist der nichtlinear-optische Kristall derart beschaffen, daß er entweder als Frequenzverdoppler für eine einzelne Strahlungsfrequenz wirkt oder daß er die Summenfrequenz aus mehreren verschiedenen Strahlungsfrequenzen der Lichtemissionseinrichtung erzeugen kann, wobei das Konversionselement ein Lumineszenz-Konversionselement ist. Für letzteres kann entweder ein organischer Farbstoff oder ein anorganischer Leuchtstoff, insbesondere ein Phosphor wie beispielsweise Cer-dotiertes YAG, verwendet werden.

Im einfachsten Fall ist der nichtlinear-optische Kristall somit ein konventioneller Frequenzverdoppler, der aus einer einzelnen in dem emittierten Strahlungsbündel enthaltenen Strahlungsfrequenz die zweite Harmonische erzeugt. Der nichtlinear-optische Kristall kann jedoch auch zusätzlich die Eigenschaft aufweisen, daß er aus zwei oder auch mehr verschiedenen Strahlungsfrequenzen des emittierten Strahlungsbündels eine Summenfrequenz erzeugt.

Die Lichtemissionseinrichtung ist vorzugsweise eine Laserstrahlquelle, da für eine effiziente Frequenzverdopplung oder Frequenzmischung die Strahlintensität des in den nichtlinear-optischen Kristall eingekoppelten Strahlungsbündels eine wichtige Rolle spielt. Der Verdopplungswirkungsgrad η verhält sich wie η - I², d.h. er steigt quadratisch mit der eingestrahlten Lichtintensität I = P/A (P = Lichtleistung, A = Fläche) an. Es kann daher auch von Vorteil sein, die Lichtemissionseinrichtung gepulst zu betreiben, da z.B. bereits eine Verdopplung der Pulshöhe eine Vervierfachung des Verdopplungswirkungsgrades zur Folge hat.

Die Laserstrahlquelle ist vorzugsweise ein Festkörperlaser. Als solcher bietet sich natürlich insbesondere eine Laserdiode, im vorliegenden Fall also eine im roten oder infraroten Spektralbereich emittierende Laserdiode, an. Hier können insbesondere die sogenannten Vertikalresonator-Laserdioden (VCSELs) verwendet werden, die nur eine geringe Strahldivergenz aufweisen und deren Strahlen mit einem Mikrolinsenarray kollimiert werden können. Diese oder auch andere Arten von Laserdioden können in einem Array angeordnet werden, welches einem Plättchen aus einem nichtlinear-optischen Kristall gegenüberliegt, so daß jede Laserdiode ein Strahlungsbündel emittiert, welches an jeweils einer eigenen Stelle durch das nichtlinear-optische Kristallplättchen hindurch tritt. Auf der gegenüberliegenden Oberfläche des nichtlinear-optischen Kristallplättchens kann das Konversionselement, also beispielsweise ein Leuchtstoff, direkt aufgebracht sein oder in einem Abstand davon angeordnet sein.

Es kann jedoch auch ein anderer Festkörper, wie beispielsweise ein Nd:YAG-Laser verwendet werden.

Das Material des nichtlinear-optischen Elements kann aus der Gruppe KH₂PO₄, KNbO₃, BaNaNbO₁₅ (Banana-Kristall), LiIO₃, KTiOPO₄ (KTP), LiNbO₃ (Lithiumniobat), LiB₃O₅ (LBO), oder β-BaB₂O₄ (BBO) oder eines anderen nichtlinear-optischen Kristallmaterials ausgewählt sein.

Das Konversionselement ist bei dieser ersten Ausführungsform ein Konversionselement. Vorzugsweise wird dabei ein Leuchtstoff, also im weitesten Sinne ein Phosphor eingesetzt. Wenn das den nichtlinear-optischen Kristall verlassende Strahlungsbündel im wesentlichen im blauen Spektralbereich liegt, so ist insbesondere die Verwendung von Cer-dotiertem Yttrium-Aluminiumgranat (YAG:Ce) besonders vorteilhaft, da dieser Phosphor das blaues Licht besonders effizient in gelbes Licht umwandelt, so daß eine derartige teilweise Konversion eine Mischung aus blauem und gelbem Licht erzeugt, welche in besonders zufriedenstellendem Maße den physiologischen Eindruck einer Weißlichtquelle erzeugt.

In einer zweiten Ausführungsform ist der nichtlinear-optische Kristall ein optisch-parametrischer Oszillator (OPO) und das Konversionselement ist ein zweites nichtlinear-optisches Element, welches der Frequenzverdopplung und Summenfrequenzerzeugung fähig ist. Diese zweite Ausführungsform beschreibt somit den umgekehrten Weg wie die erste Ausführungsform, da in dem OPO-Kristall aus der Anregungswellenlänge zunächst längere Wellenlängen erzeugt werden ("down-conversion") und erst im zweiten Schritt in dem zweiten nichtlinear-optischen Element wieder kürzere Wellenlängen erzeugt werden ("up-conversion").

Auch bei dieser Ausführungsform können die schon für die erste Ausführungsform genannten Lichtemissionseinrichtungen verwendet und es können für die nichtlinear-optischen Elemente die dort bereits genannten Materialien verwendet werden.

Im folgenden werden Ausführungsbeispiele der vorliegenden Erfindung anhand der Zeichnungen näher erläutert. Es zeigen:
- Fig. 1: eine schematische Darstellung der ersten Ausfüh- rungsform der Weißlichtquelle gemäß der vorliegen- den Erfindung;
- Fig. 2: eine schematische Darstellung der zweiten Ausfüh- rungsform der Weißlichtquelle gemäß der vorliegen- den Erfindung;
- Fig. 3: ein praktisches Ausführungsbeispiel für eine erfin- dungsgemäße Weißlichtquelle unter Verwendung eines Arrays von Lichtemissionseinrichtungen.

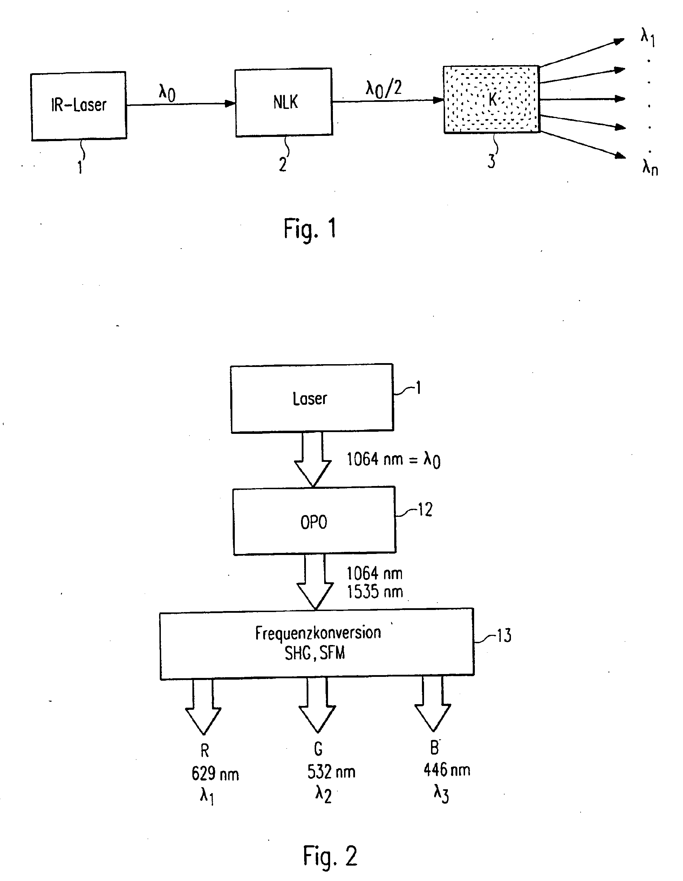

Die schematische Darstellung der ersten Ausführungsform in der Fig. 1 zeigt eine Lichtemissionseinrichtung 1, im vorliegenden Fall einen Infrarot(IR-)Laser, insbesondere eine IR-Laserdiode, welche ein vorzugsweise schmalbandiges Emissionsspektrum mit einem Maximum bei einer Wellenlänge λ₀ aufweist. Für den Fall der Verwendung einer Laserdiode bietet sich beispielsweise eine Vertikalresonator-Laserdiode (VCSEL) an, welche bekanntermaßen oberflächenemittierend ist und einen relativ schwach divergenten Strahl emittiert. In diesem Fall können auch mehrere VCSELs als Array auf einem gemeinsamen Halbleitersubstrat geformt werden, über die ein Mikrolinsenarray zur Kollimierung der Strahlen angebracht wird. Es kann jedoch auch ein anderer Festkörperlaser, beispielsweise ein Nd:YAG-Laser, verwendet werden, welcher bei einer Wellenlänge von 1064 nm emittiert.

Die Lichtemissionseinrichtung 1 wird vorzugsweise gepulst betrieben, da die erfindungswesentlichen Prozesse wie Frequenzverdopplung oder Summen- bzw. Differenzfrequenzerzeugung in ihrer Effizienz proportional zum Quadrat der Lichtleistung sind.

Das von der Lichtemissionseinrichtung 1 emittierte Strahlungsbündel mit dem Hauptmaximum bei der Wellenlänge λ₀ wird einem nichtlinear-optischen Kristall 2 zugeführt, in welchem bei der vorliegenden Ausführungsform im einfachsten Fall eine Frequenzverdopplung durchgeführt wird, die beispielsweise durch die bekannte Typ-II-Phasenanpassung erfolgen kann. Dementsprechend erzeugt der nichtlinear-optische Kristall 2 ein Strahlungsbündel mit einem Emissionsmaximum bei einer Wellenlänge λ₀/2. Als Materialien für den nichtlinear-optischen Kristall 2 können alle derzeit bekannten Arten verwendet werden. Bevorzugte Materialien sind KH₂PO₄, (KDP), KNbO₃ (Kaliumniobat), BaNaNbO₁₅ (Banana-Kristall), LiIO₃, KTiOPO₄ (KTP), LiNbO₃ (Lithiumniobat), LiB₃O₅ (LBO), β-BaB₂O₄ (BBO).

Wenn die IR-Laserdiode beispielsweise bei einer Wellenlänge λ₀ = 920 nm emittiert, so erzeugt der nichtlinear-optische Kristall 2 ein Signal bei der zweiten Harmonischen, d.h. einer Wellenlänge λ₀/2 = 460 nm. Auf diese Weise kann man mit der IR-Laserdiode und dem nichtlinear-optischen Kristall 2 die üblicherweise in Weißlichtquellen dieser Art verwendete GaN- bzw. InGaN-Lumineszenz- bzw. Laserdiode ersetzen.

Mit der frequenzverdoppelten Strahlung wird dann in an sich bekannter Weise ein Konversionselement 3 beaufschlagt, mit welchem eine Ausgangsstrahlung mit Wellenlängen λ₁ ...λₙ erzeugt wird, die zueinander komplementärfarbige Spektralbereiche aufweisen. Die Wellenlängen λ₁ ... λₙ können somit beispielsweise im blauen und im gelben Spektralbereich liegen oder sie können durch ein Farbtripel im roten, grünen und blauen Spektralbereich gebildet sein. In beiden Fällen wird durch die additive Mischung der Farben weißes Licht erzeugt.

Das Konversionselement 3 ist in der vorliegenden Ausführungsform ein Lumineszenz-Konversionselement. Dieses kann einerseits durch organische Farbstoffmoleküle gebildet sein, die in eine geeignete Matrix eingebettet sind. Es kann andererseits durch einen anorganischen Leuchtstoff wie einen Phosphor gebildet sein. Besonders bevorzugt ist diesbezüglich Cer-dotiertes Yttrium-Aluminiumgranat (YAG:Ce), da dieses bekanntermaßen eine effiziente Umwandlung von blauem in gelbes Licht ermöglicht. In diesem Fall würde also ein Teil des eingangsseitig in das Konversionselement 3 eintretenden blauen Lichts ungehindert hindurchtreten und sich mit dem konvertierten gelben Licht zu Weißlicht mischen.

Das Konversionselement 3 kann auch durch ein Halbleitermaterial oder durch ein Schichtsystem aus unterschiedlichen Halbleitermaterialien gebildet werden.

Es ist ebenso denkbar, daß das von der Lichtemissionseinrichtung 1 emittierte Strahlungsbündel mehrere Strahlungsfrequenzen aufweist und in dem nichtlinear-optischen Kristall 2 eine Summenfrequenz erzeugt wird.

Bei der oben beschriebenen ersten Ausführungsform wird somit in einem ersten Schritt in dem nichtlinear-optischen Kristall 2 zunächst eine Aufwärtskonversion der zugeführten Lichtstrahlung vorgenommen, während anschließend in einem zweiten Schritt die aufwärtskonvertierte Lichtstrahlung in dem Konversionselement 3 derart aufzueinander komplementärfarbige Wellenlängen verteilt wird, daß im Ergebnis weißes Licht erzeugt wird.

Die in der Fig. 2 dargestellte zweite Ausführungsform der vorliegenden Erfindung geht gewissermaßen den umgekehrten Weg, indem hier zunächst durch Abwärtskonversion Wellenlängen erzeugt werden, die größer als die Ausgangswellenlänge sind, und anschließend diese Wellenlängen durch Frequenzverdopplung und Summenfrequenzbildung aufwärtskonvertiert werden.

Der Reihe nach wird auch bei der zweiten Ausführungsform eine Lichtemissionseinrichtung 1, im vorliegenden Fall ein Nd:YAG-Laser, verwendet, der eine Wellenlänge von λ₀ = 1064 nm erzeugt. In der vorliegenden Ausführungsform wird das nichtlinear-optische Element durch einen optisch-parametrischen Oszillator (OPO) 12 gebildet. In diesem wird in an sich bekannter Weise die Eingangsstrahlung bei der Wellenlänge λ₀ = 1064 nm in Teilstrahlen mit den Wellenlängen 1535 nm und 3468 nm aufgespalten. Die Resonatorspiegel des OPO-Kristalls 12, d.h. in der Regel die verspiegelten Oberflächen des OPO-Kristalls sind bezüglich ihrer Wellenlängenselektivität derart gewählt, daß in dem vorliegenden Ausführungsbeispiel die Wellenlänge 3468 nm keine Verstärkung innerhalb des Resonators erfährt und die Resonatorspiegel lediglich bei der Wellenlänge 1535 nm eine hohe Reflektivität aufweisen. Somit treten durch den OPO-Kristall 12 nur die Pumpwellenlänge 1064 nm und die von ihr erzeugte Wellenlänge 1535 nm hindurch.

Das Konversionselement 13 ist im vorliegenden Fall der zweiten Ausführungsform ein zweiter nichtlinear-optischer Kristall, in welchem eine Frequenzverdopplung und Summenfrequenzerzeugung der Wellenlängen des von dem OPO-Kristall 12 emittierten Strahlungsbündels durchgeführt wird. In dem vorliegenden Ausführungsbeispiel wird eine erste Wellenlänge λ₁ = 629 nm durch Summenfrequenzbildung der beiden Wellenlängen 1064 nm und 1535 nm der Eingangsstrahlung erzeugt. Eine zweite Wellenlänge λ₂ = 532 nm wird durch Frequenzverdopplung der erstgenannten Wellenlänge erzeugt. Eine dritte Wellenlänge λ₃ = 446 nm wird durch Summenfrequenzbildung aus der erstgenannten Wellenlänge mit der frequenzverdoppelten zweitgenannten Wellenlänge erzeugt.

Auf diese Weise werden drei komplementärfarbige Wellenlängen erzeugt, nämlich rot, grün und blau, deren additive Farbmischung weißes Licht ergibt.

Auch bei der zweiten Ausführungsform kann als Lichtemissionseinrichtung eine Laserdiode wie ein VCSEL verwendet werden.

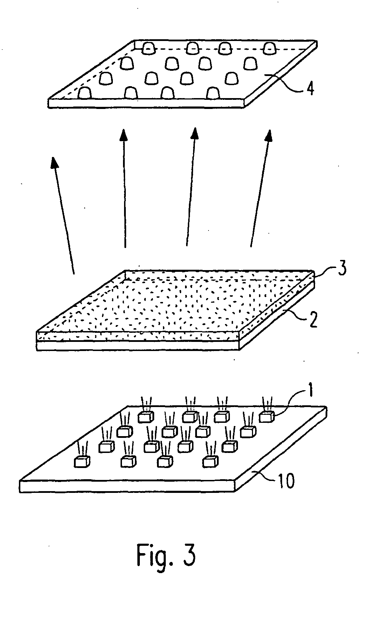

In Fig. 3 ist schließlich noch eine praktische Ausführungsform für eine erfindungsgemäße Weißlichtquelle dargestellt. In dieser sind auf einem Halbleitersubstrat 10 eine Mehrzahl von matrixartig angeordneten Lichtemissionseinrichtungen 1, insbesondere Vertikalresonator-Laserdioden (VCSEL), geformt, durch die mit Hilfe von Mikrolinsen Strahlungsbündel im infraroten Spektralbereich emittiert werden. In Abstrahlrichtung der Laserdioden ist zunächst ein nichtlinear-optischer Kristall 2, beispielsweise in Form eines LiNb₃-Plättchens angeordnet, durch welches die von den emittierten Strahlungsbündeln zweite Harmonische erzeugt wird. Vorzugsweise ist zwischen den Laserdioden und dem Lithiumniobat-Plättchen noch eine Linsenanordnung montiert, die aus einer matrixartigen. Vielzahl von Einzellinsen besteht, durch die jedes der Strahlungsbündel optimal auf je eine eigene Stelle des Lithiumniobat-Plättchens fokussiert wird. Für eine effiziente Frequenzverdopplung ist erforderlich, daß die Wellenfronten der Strahlungsbündel in der Ebene des Lithiumniobat-Plättchens möglichst eben sind.

Auf die den Laserdioden abgewandte Oberfläche des Lithiumniobat-Plättchens ist ein Konversionselement 3, insbesondere ein Lumineszenz-Konversionselement 3, aufgebracht. Dieses kann beispielsweise aus einem Leuchtstoff wie einem Phosphor bestehen. Dieser ist vorzugsweise in Form von Leuchtstoffpartikeln in einer transparenten Einbettungsmasse dispergiert, die auf dem Lithiumniobat-Plättchen aufgebracht wurde. Alternativ dazu kann das Konversionselement 3 auch separat von dem nichtlinear-optischen Kristall 2 angeordnet werden. Schließlich kann noch eine weitere Linse, insbesondere eine Fresnel-Linse, vorgesehen sein, um das erzeugte Weißlicht ins Unendliche zu projizieren.

Oberhalb des Lithiumniobat-Plättchens ist ein Mikrolinsenarray 4 angeordnet, welches eine matrixartige Anordnung von einzelnen Mikrolinsen aufweist, die jeweils einzelnen Laserdioden zugeordnet sind.

Das dargestellte praktische Ausführungsbeispiel kann auch durch die zweite Ausführungsform gebildet werden. Hierbei ist der nichtlinear-optische Kristall 2 durch einen OPO-Kristall gebildet und das Konversionselement 3 ist durch einen zweiten nichtlinear-optischen Kristall gebildet.

## Patentansprüche

1. Weißlichtquelle, mit
- einer Lichtemissionseinrichtung (1) zur Emission eines Strahlungsbündels mit einer oder mehreren Strahlungsfrequenzen im roten oder infraroten Spektralbereich,
- einem nichtlinear-optischen Element (2), in welches das emittierte Strahlungsbündel eingekoppelt und zumindest teilweise durch Erzeugung von mindestens einer Mischfrequenz mittels Frequenzmischung und/oder Frequenzverdopplung und/oder Summen- oder Differenzfrequenzbildung in ein frequenzgemischtes Strahlungsbündel umgewandelt wird, und
- einem Konversionselement (3), in welches das frequenzgemischte Strahlungsbündel eingekoppelt und derart mindestens teilweise in Lichtstrahlung größerer oder kleinerer Wellenlängen umgewandelt wird, daß das Emissionsspektrum des von dem Konversionselement (3) abgestrahlten Strahlungsbündels zueinander komplementärfarbige Spektralbereiche aufweist.

2. Weißlichtquelle, mit
- einer Lichtemissionseinrichtung (1) zur Emission eines Strahlungsbündels mit einer oder mehreren Strahlungsfrequenzen im roten oder infraroten Spektralbereich,
- einem nichtlinear-optischen Element (2), in welches das emittierte Strahlungsbündel eingekoppelt und zumindest teilweise durch Erzeugung von mindestens einer Mischfrequenz mittels Frequenzmischung und/oder Frequenzverdopplung und/oder Summen- oder Differenzfrequenzbildung in ein frequenzgemischtes Strahlungsbündel umgewandelt wird, und
- einem Konversionselement (3), in welches das frequenzgemischte Strahlungsbündel eingekoppelt und derart mindestens teilweise in Lichtstrahlung größerer oder kleinerer Wellenlängen umgewandelt wird, daß das Emissionsspektrum des von dem Konversionselement (3) abgestrahlten Strahlungsbündels Spektralanteile im roten, grünen und blauen Spektralbereich aufweist.

3. Weißlichtquelle nach Anspruch 1 oder 2,
**dadurch gekennzeichnet, daß**
- das nichtlinear-optische Element (2) derart beschaffen ist, daß es entweder als Frequenzverdoppler für eine einzelne Strahlungsfrequenz wirkt oder daß es die Summenfrequenz aus mehreren verschiedenen Strahlungsfrequenzen der Lichtemissionseinrichtung (1) erzeugen kann, und daß
- das Konversionselement (3) ein Lumineszenz-Konversionselement ist, insbesondere entweder ein organischer Farbstoff, ein anorganischer Leuchtstoff, wie ein Phosphor, oder ein Halbleiter.

4. Weißlichtquelle nach Anspruch 1 oder 2,
**dadurch gekennzeichnet, daß**
- das nichtlinear-optische Element (2) ein optisch-parametri- _ scher Oszillator (OPO) ist, und
- das Konversionselement (3) ein zweites nichtlinear-optisches Element ist, welches der Frequenzverdopplung und Summenfrequenzerzeugung fähig ist.

5. Weißlichtquelle nach einem der vorhergehenden Ansprüche,
**dadurch gekennzeichnet, daß**
- die Lichtemissionseinrichtung (1) eine Laserstrahlquelle, insbesondere ein Festkörperlaser, ist.

6. Weißlichtquelle nach Anspruch 5,
**dadurch gekennzeichnet, daß**
- der Festkörperlaser eine kantenemittierende Laserdiode oder eine Vertikalresonator-Laserdiode (VCSEL), insbesondere aus GaAlAs, InGaAlAs, InGaAs bzw. InGaAlP, ist.

7. Weißlichtquelle nach Anspruch 5,
**dadurch gekennzeichnet, daß**
- der Festkörperlaser (1) ein Nd:YAG-Laser ist.

8. Weißlichtquelle nach einem der vorhergehenden Ansprüche,
**dadurch gekennzeichnet, daß**
- die Lichtemissionseinrichtung (1) für einen gepulsten Betrieb verwendbar ist.

9. weißlichtquelle nach einem der vorhergehenden Ansprüche, **dadurch gekennzeichnet, daß**
- das Material des nichtlinear-optischen Element (2) aus der Gruppe KH₂PO₄, KNbO₃, BaNaNbO₁₅, LiIO₃, KTiOPO₄ (KTP), LiNbO₃, LiB₃O₅, β-BaB₂O₄ ausgewählt ist.

10. Weißlichtquelle nach einem der vorhergehenden Ansprüche, **dadurch gekennzeichnet, daß**
- eine Mehrzahl von Lichtemissionseinrichtungen (1) auf einem gemeinsamen Substrat angeordnet ist.

11. Weißlichtquelle nach Anspruch 10,
**dadurch gekennzeichnet, daß**
- die Lichtemissionseinrichtungen (1) Vertikalresonator-Laserdioden (VCSELs) sind, die auf einem gemeinsamen Halbleitersubstrat (10) geformt sind.

12. Weißlichtquelle nach Anspruch 10 oder 11,
**dadurch gekennzeichnet, daß**
- die von den Lichtemissionseinrichtungen (1) emittierten Strahlungsbündel durch je eine Stelle eines gemeinsamen nichtlinear-optischen Elements (2) hindurchtreten.

13. Weißlichtquelle nach Anspruch 12,
**dadurch gekennzeichnet, daß**
- das Konversionselement (3) unmittelbar auf der den Lichtemissionseinrichtungen (1) abgewandten Oberfläche des nichtlinear-optischen Elements (2) aufgebracht ist.

## Claims

1. White light source, having
- a light emission device (1) for the emission of a radiation beam with one or more radiation frequencies in the red or infrared spectral region,
- a nonlinear-optical element (2), into which the emitted radiation beam is coupled and is converted into a frequency-mixed radiation beam at least partially by generation of at least one mixed frequency by means of frequency mixing and/or a frequency doubling and/or summation or difference frequency formation, and
- a conversion element (3) into which the frequency-mixed radiation beam is coupled and in such a way is converted at least partially into light radiation of longer or shorter wavelengths, that the emission spectrum of the radiation beam radiated by the conversion element (3) has mutually complementarily colored spectral regions.

2. White light source, having
- a light emission device (1) for the emission of a radiation beam with one or more radiation frequencies in the red or infrared spectral region,
- a nonlinear-optical element (2), into which the emitted radiation beam is coupled and is converted into a frequency-mixed radiation beam at least partially by generation of at least one mixed frequency by means of frequency mixing and/or a frequency doubling and/or summation or difference frequency formation, and
- a conversion element (3) into which the frequency-mixed radiation beam is coupled and in such a way is converted at least partially into light radiation of longer or shorter wavelengths, that the emission spectrum of the radiation beam radiated by the conversion element (3) has spectral components in the red, green and blue spectral region.

3. White light source according to Claim 1 or 2,
**characterized in that**
- the nonlinear-optical element (2) is configured in such a way that it either acts as frequency doubler for an individual radiation frequency or that it can generate the summation frequency from a plurality of different radiation frequencies of the light emission device (1), and **in that**
- the conversion element (3) is a luminescence conversion element, in particular either an organic dye, an inorganic luminescent material, such as phosphor, or a semiconductor.

4. White light source according to Claim 1 or 2,
**characterized in that**
- the nonlinear-optical element (2) is an optical-parametric oscillator (OPO), and
- the conversion element (3) is a second nonlinear-optical element which is capable of frequency doubling and summation frequency generation.

5. White light source according to one of the preceding claims,
**characterized in that**
- the light emission device (1) is a laser beam source, in particular a solid-state laser.

6. White light source according to Claim 5,
**characterized in that**
- the solid-state laser is an edge-emitting laser diode or a vertical resonator laser diode (VCSEL), in particular made of GaAlAs, InGaAls, InGaAs or InGaAlP.

7. White light source according to Claim 5, **characterized in that**
- the solid-state laser (1) is an Nd:YAG laser.

8. White light source according to one of the preceding claims,
**characterized in that**
- the light emission device (1) can be used for a pulsed operation.

9. White light source according to one of the preceding claims,
**characterized in that**
- the material of the nonlinear-optical element (2) is selected from the group KH₂PO₄, KNbO₃, BaNaNbO₁₅, LiIO₃, KTiOPO₄ (KTP), LiNbO₃, LiB₃O₅, β-BaB₂O₄.

10. White light source according to one of the preceding claims,
**characterized in that**
- a plurality of light emission devices (1) are arranged on a common substrate.

11. White light source according to Claim 10,
**characterized in that**
- the light emission devices (1) are vertical resonator laser diodes (VCSELs) which are formed on a common semiconductor substrate (10).

12. White light source according to Claim 10 or 11,
**characterized in that**
the radiation beams emitted by the light emission devices (1) pass through a respective location of a common nonlinear-optical element (2).

13. White light source according to Claim 12,
**characterized in that**
the conversion element (3) is applied directly on that surface of the nonlinear-optical element (2) which is remote from the light emission devices (1).

## Revendications

1. Source de lumière blanche, comprenant
- un dispositif d'émission de lumière (1) pour l'émission d'un faisceau de rayonnement avec une ou plusieurs fréquences de rayonnement dans la plage spectrale rouge ou infrarouge,
- un élément (2) optique non linéaire, dans lequel le faisceau de rayonnement émis est injecté et transformé au moins partiellement par génération d'au moins une fréquence mixte par mélange de fréquences et/ou doublement de fréquence et/ou formation de fréquence cumulée ou de fréquence différentielle en un faisceau de rayonnement mixte au niveau de la fréquence, et
- un élément de conversion (3), dans lequel le faisceau de rayonnement mixte au niveau de la fréquence est injecté et converti au moins partiellement en rayonnement de lumière de longueurs d'onde supérieures ou inférieures, de sorte que le spectre d'émission du faisceau de rayonnement émis par l'élément de conversion (3) présente des plages spectrales complémentaires les unes par rapport aux autres.

2. Source de lumière blanche, comprenant
- un dispositif d'émission de lumière (1) pour l'émission d'un faisceau de rayonnement avec une ou plusieurs fréquences de rayonnement dans la plage spectrale rouge ou infrarouge,
- un élément (2) optique non linéaire, dans lequel le faisceau de rayonnement émis est injecté et converti au moins partiellement par génération d'au moins une fréquence mixte par mélange de fréquences et/ou doublement de fréquence et/ou formation de fréquence cumulée ou de fréquence différentielle en un faisceau de rayonnement mixte au niveau de la fréquence, et
- un élément de conversion (3) dans lequel le faisceau de rayonnement mixte au niveau de la fréquence est injecté et est converti au moins partiellement en rayonnement de lumière de longueurs d'onde supérieures ou inférieures, de sorte que le spectre d'émission du faisceau de rayonnement émis par l'élément de conversion (3) présente des fractions spectrales dans la plage spectrale rouge, verte et bleue.

3. Source de lumière blanche selon la revendication 1 ou 2
**caractérisée en ce que**
- l'élément (2) optique non linéaire est constitué de telle sorte qu'il agit soit comme doubleur de fréquence pour une fréquence de rayonnement individuelle ou de telle sorte qu'il peut générer la fréquence cumulée à partir de plusieurs fréquences de rayonnement différentes du dispositif d'émission de lumière (1), et **en ce que**
- l'élément de conversion (3) est un élément de conversion de luminescence, en particulier un colorant organique, une substance fluorescente inorganique, telle qu'un phosphore, ou un semi-conducteur.

4. Source de lumière blanche selon la revendication 1 ou 2
**caractérisée en ce que**
- l'élément (2) optique non linéaire est un oscillateur paramétrique et optique (OPO), et
- l'élément de conversion (3) est un second élément optique non linéaire, qui est apte au doublement de fréquence et à la génération de fréquence cumulée.

5. Source de lumière blanche selon l'une quelconque des revendications précédentes, **caractérisée en ce que**
- le dispositif d'émission de lumière (1) est une source de faisceau laser, en particulier un laser solide.

6. Source de lumière blanche selon la revendication 5,
**caractérisée en ce que**
- le laser solide est une diode laser émettant par la tranche ou une diode laser à résonateur vertical (VCSEL), en particulier à base de GaAlAs, InGaAlAs, InGaAs ou InGaAlP.

7. Source de lumière blanche selon la revendication 5
**caractérisée en ce que**
- le laser solide (1) est un laser Nd:YAG.

8. Source de lumière blanche selon l'une quelconque des revendications précédentes,
**caractérisée en ce que**
- le dispositif d'émission de lumière (1) peut être utilisé pour un mode pulsé.

9. Source de lumière blanche selon l'une quelconque des revendications précédentes,
**caractérisée en ce que**
- le matériau de l'élément (2) optique non linéaire est choisi dans le groupe KH₂PO₄, KNbO₃, BaNaNbO₁₅, LiIO₃, KTiOPO₄ (KTP), LiNbO₃, LiB₃O₅, β-BaB₂O₄.

10. Source de lumière blanche selon l'une quelconque des revendications précédentes,
**caractérisée en ce que**
- une pluralité de dispositifs d'émission de lumière (1) est disposée sur un substrat commun.

11. Source de lumière blanche selon la revendication 10,
**caractérisée en ce que**
- les dispositifs d'émission de lumière (1) sont des diodes laser à résonateur vertical (VCSEL), qui sont formées sur un substrat semi-conducteur (10) commun.

12. Source de lumière blanche selon la revendication 10 ou 11,
**caractérisée en ce que**
- les faisceaux de rayonnement émis par les dispositifs d'émission de lumière (1) passent chacun à travers un emplacement d'un élément (2) optique non linéaire commun.

13. Source de lumière blanche selon la revendication 12,
**caractérisée en ce que**
- l'élément de conversion (3) est appliqué directement sur la surface, opposée aux dispositifs d'émission de lumière (1), de l'élément (2) optique non linéaire.
